(19) Europäisches Patentamt
European Patent Office
Office européen des brevets

(11) **EP 3 319 903 B1**

(12) **EUROPEAN PATENT SPECIFICATION**

(45) Date of publication and mention
of the grant of the patent:
**11.03.2020 Bulletin 2020/11**

(51) Int Cl.:
*C01B 25/08* (2006.01)    *C01G 28/00* (2006.01)
*C01G 29/00* (2006.01)    *C01G 30/00* (2006.01)

(21) Application number: **16734571.9**

(86) International application number:
**PCT/EP2016/063615**

(22) Date of filing: **14.06.2016**

(87) International publication number:
**WO 2017/008979 (19.01.2017 Gazette 2017/03)**

(54) **INORGANIC SEMICONDUCTING COMPOUNDS**

ANORGANISCHE HALBLEITERVERBINDUNGEN

COMPOSÉS SEMI-CONDUCTEURS INORGANIQUES

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **10.07.2015 EP 15176311**

(43) Date of publication of application:
**16.05.2018 Bulletin 2018/20**

(73) Proprietor: **Technische Universität München
80333 München (DE)**

(72) Inventors:
• **NILGES, Tom
85737 Ismaning (DE)**
• **PFISTER, Daniela
68259 Mannheim (DE)**
• **OTT, Claudia
82377 Penzberg (DE)**
• **SCHÄFER, Konrad
80937 München (DE)**
• **BAUMGARTNER, Maximilian
84489 Burghausen (DE)**
• **WEIHRICH, Richard
93047 Regensburg (DE)**

(74) Representative: **Vossius & Partner
Patentanwälte Rechtsanwälte mbB
Siebertstrasse 3
81675 München (DE)**

(56) References cited:
• **HANS-GEORG VON SCHNERING ET AL:
"Ge38P8J8 und Ge38As8J8, eine neue
Verbindungsklasse mit Käfigstruktur",
ANGEWANDTE CHEMIE, vol. 84, no. 1, 1 January
1972 (1972-01-01), pages 30-31, XP055234709, DE
ISSN: 0044-8249, DOI:
10.1002/ange.19720840109 cited in the
application**
• **DAVID A HEADSPITH ET AL: "Transition Metal
Pnictide-Halides: A Class of Under-Explored
Compounds", TOPICS IN CATALYSIS, KLUWER
ACADEMIC PUBLISHERS-PLENUM
PUBLISHERS, NE, vol. 52, no. 11, 12 May 2009
(2009-05-12), pages 1611-1627, XP019734217,
ISSN: 1572-9028, DOI:
10.1007/S11244-009-9282-5**

**Description**

The invention concerns a new class of semiconducting inorganic compounds which, due to the arrangement of their constituting atoms in the form of a double helix, can be advantageously provided as nanomaterials, such as nanowires. The inorganic semiconducting compounds can be used in a variety of applications, in particular in semiconductive devices for the conversion of energy, including solar cells or thermoelectric devices, in sensor devices, for the provision of displays, or as photocatalysts.

With a view to the efficient provision of nanoscale materials, the synthesis of helical structures is of substantial interest because of the useful physical and electronic properties that can be expected of materials showing such structures (Zhao, M. Q., et al., Nanoscale 2014, 6, 9339). However, while the synthesis of double helical assemblies from organic substances has been shown to be feasible due to the variable shapes and complex interactions of such substances, corresponding inorganic structures are much more difficult to accomplish. The lack of directed inter- and intramolecular interactions in the case of simple atoms renders a self-assembly into purely inorganic double helices more challenging. In the case of carbon-based inorganic materials with (double) helical structures like carbon nano tubes (Iijima, S. et al., Nature 1993, 363, 603), a large quantity of unwanted byproducts (single helical or non-coiled fibers) renders a characterization rather challenging. A complex carbon containing inorganic double helix system $[(CH_3)_2NH_2]K_4[V_{10}O_{10}(H_2O)_2(OH)_4-(PO_4)_7]\cdot 4H_2O$, has been reported (Soghomonian et al., Science 1993, 259, 1596), where a double helix is formed by metal oxo species. Structures containing simple atomic helices are predicted for Li and P (Ivanov, A. S., et al., Angew. Chem. Int. Ed. 2012, 51, 8330). For the preparation of micro-sized and even more complicated nano-sized inorganic, carbon-free helical structures in bottom-up and top-down approaches, significant efforts are required (Zhao, M. Q., et al., Nanoscale 2014, 6, 9339; Liu, L. et al., Nanoscale 2014, 6, 9355). Molecular self-assembly or nano-particle self-assembly strategies or templating are bottom-up strategies which allowed for instance the preparation of helical structures containing CdS or GaN (Sone, E.D. et al., Small 2005, 1, 694; Goldberger, J. et al., Nature 2003, 422, 599). In none of the mentioned cases a single-atomic helical chain is realized. Top-down strategies were reported based on solution-chemical procedures e.g. for the formation of alloyed Au/Ag nanowires (Wang, Y., JACS 2011, 133, 20060), or based on the use of Zintl compound precursors like NaSi to form Si microtubes (Morito, H., Angew. Chem. Int. Ed. 2010, 49, 3628).

Particularly challenging is the design and the preparation of nanoparticles in the sub-5nm-regime. A DNA nanocasting approach has been proposed to prepare 3D inorganic nanostructures with predefined dimensions, shapes and surfaces (Sun, W. et al., Science 2014, 346, 6210). Here, linear fragments of DNA are used to provide predefined molds wherein nanoparticles are formed.

Quantum confined semiconductors with dimensions on a nanometer scale are widely used. Solar cells, thermoelectric devices, optical devices and sensors are key applications where semiconducting materials of sizes significantly smaller than 50 nm are implemented (Graetzel, M., et al., Nature 2012, 488, 304; Boukai, A. I.et al., Nature 2008, 451, 168). A recent all solid state dye-sensitized CsSnI$_3$ based solar cell reached efficiencies larger than 10% (Chung, I. et al., Nature 2012, 485, 486). Furthermore, thermoelectric devices with a figure of merit larger than 2, realized by nanosized precipitates of lead telluride based compounds were reported (Biswas, K., et al., Nature 2012, 489, 414). However, in both cases toxic, less abundant, and/or expensive elements and complex nano-structuring are needed to provide efficient nano-structured materials for such applications.

The present invention provides a class of semiconducting compounds showing a structure wherein the constituting atoms arrange themselves in the form of a double helix without the need for an external template, or for complex precursor structures. These compounds combine one or more elements of group 14, one or more elements of group 15 and one or more elements of group 17 of the periodic table in (molar) amounts such that the resulting stoichiometry can be schematically represented as (group 14 element(s)): (group 15 element(s)):(group 17 element(s)) = 1:1:1. However, changes in the electronic properties of these compounds via incorporation of dopant elements of group 13 or 16 are also encompassed by the invention. Compounds of group 14/15/17 elements with other stoichiometries, i.e. Ge$_{38}$E$_8$I$_8$ with E=P, As, Sb (von Schnering, H.G. et al., Angew. Chem. 1972, 84, 30, and von Schnering, H.G., Z. Anorg. Chem. 1973, 395, 223), Sn$_{24}$P$_{19.3}$I$_8$ and Sn$_{24}$As$_{19.3}$I$_8$ (Shatruk M. M., et al., Inorg. Chem. 1999, 38, 3455) had been reported as taking the form of a type I clathrate.

Thus, in a first embodiment, the invention provides a compound of formula (Ia):

$$M^A_{1-x}M^B_xX^A_{1-y}X^B_yQ^A_{1-z}Q^B_z \qquad (Ia),$$

wherein:

M$^A$    is an element selected from Si, Ge, Sn, and Pb,

M$^B$    is an element selected from Si, Ge, Sn, and Pb and from combinations thereof such that M$^B$ is not the same as M$^A$ and does not contain M$^A$, and

x is 0 to 0.50;

$X^A$ is an element selected from F, Cl, Br and I,

$X^B$ is an element selected from F, Cl, Br and I and from combinations thereof such that $X^B$ is not the same as $X^A$ and does not contain $X^A$, and

y is 0 to 0.50;

$Q^A$ is an element selected from P, As, Sb and Bi,

$Q^B$ is an element selected from P, As, Sb and Bi and from combinations thereof such that $Q^B$ is not the same as $Q^A$ and does not contain $Q^A$, and

z is 0 to 0.50.

In a further embodiment, the invention provides a compound which represents a doped variant of the compound of formula (Ia), and which further contains:

(i) an element $M^D$, selected from Al, Ga, In and from combinations thereof, in a maximum amount of 10 mol% based on the total molar amount of $M^A$ and $M^B$, which element $M^D$ may partially replace $M^A$ and/or $M^B$ in formula (Ia); and/or

(ii) an element $Q^D$, selected from S, Se, Te and from combinations thereof, in a maximum amount of 10 mol% based on the total molar amount of $X^A$, $X^B$, $Q^A$ and $Q^B$, which element $Q^D$ may partially replace $X^A$, $X^B$, $Q^A$ and/or $Q^B$ in formula (Ia).

As further preferred aspects, the present invention provides nanomaterials, such as a nanowire, comprising or consisting of the compound in accordance with the invention.

Still further aspects concern processes for the preparation of the compound of the invention or of the above nanomaterials.

Finally, the invention concerns the application of the compounds or the nanomaterials in accordance with the invention in particular as semiconductors in electrical, electronic, optical or optoelectronic devices, or as catalysts, in particular photocatalysts.

The compounds in accordance with the invention are either compounds of formula (Ia), or doped variants thereof. Thus, unless indicated otherwise in specific context, any reference herein to a compound or compounds in accordance with the invention encompasses the compounds of formula (Ia), the doped variants thereof and the preferred embodiments of the compounds of formula (Ia) and of the doped variants that will be illustrated below.

The compounds in accordance with the invention are provided in crystalline form, and it has been surprisingly found that the atoms constituting these compounds are arranged in the form of a double helix. Characteristics of this double helix structure will also be discussed in further detail below.

Essential components of the compounds in accordance with the invention are the elements $M^A$, $X^A$ and $Q^A$.

$M^A$ is an element of group 14 of the periodic table, which is selected from Si, Ge, Sn and Pb, which is preferably selected from Ge, Sn and Pb, and which is more preferably Sn. As further indicated in formula (Ia), it is also possible in the compounds in accordance with the invention that more than one element of group 14 is present, i.e. an element $M^A$ selected from Si, Ge, Sn and Pb or its preferred embodiments, and an element $M^B$ selected from Si, Ge, Sn and Pb and from combinations thereof, preferably selected from Ge, Sn and Pb and from combinations thereof. It will be apparent that in this case $M^B$ is not the same as $M^A$, or, if $M^B$ represents a combination of elements, that the combination does not contain $M^A$. Thus, in the preferred case where $M^A$ is Sn, it is also preferred that $M^B$, if present, is selected from Si, Ge, Pb, and from a combination thereof, more preferred that $M^B$, if present, is selected from Ge, Pb, and from a combination of the two, and most preferably $M^B$ is Pb. As will be understood by the skilled reader, the optional element(s) $M^B$ replace the element $M^A$ in the compounds in accordance with the invention by occupying sites in the crystal structure which would be occupied by $M^A$ in the absence of $M^B$. The ratio of the optional element(s) $M^B$ is defined by the index x in formula (Ia), which is 0 (i.e. element(s) $M^B$ are absent) to 0.50 (i.e. a maximum of 50 % of the sites in the crystal structure which would be occupied by the element $M^A$ can be occupied by $M^B$). Preferably, x is 0 to 0.15, more preferably 0 to 0.05.

$X^A$ is an element of group 17 of the periodic table, which is selected from F, Cl, Br and I, preferably from Br and I, and which is particularly preferably I. As further indicated in formula (Ia), it is also possible in the compounds in accordance with the invention that more than one element of group 17 is present, i.e. an element $X^A$ selected from F, Cl, Br and I or its preferred embodiments, and an element $X^B$ selected from F, Cl, Br and I, and from combinations thereof, preferably form Br and I. It will be apparent that in this case $X^B$ is not the same as $X^A$, or, if $X^B$ represents a combination of elements, that the combination does not contain $X^A$. Thus, in the particularly preferred case where $X^A$ is I, it is preferred that $X^B$, if present, is selected from F, Cl, and Br and from combinations thereof. As will be understood by the skilled reader, the optional element(s) $X^B$ replace the element $X^A$ in the compounds in accordance with the invention by occupying sites in the crystal structure which would be occupied by $X^A$ in the absence of $X^B$. The ratio of the optional element(s) $X^B$ is defined by the index y in formula (Ia), which is 0 (i.e. element(s) $X^B$ are absent) to 0.50 (i.e. a maximum of 50 % of the sites in the crystal structure which would be occupied by the element $X^A$ can be occupied by $X^B$). Preferably, y is 0 to 0.15, more preferably 0 to 0.05.

$Q^A$ is an element of group 15 of the periodic table, which is selected from P, As, Sb and Bi, preferably from P and As, and which is particularly preferably P. As further indicated in formula (Ia), it is also possible in the compounds in accordance with the invention that more than one element of group 15 is present, i.e. an element $Q^A$ selected from P, As, Sb and Bi or its preferred embodiments, and an element $Q^B$ selected from P, As, Sb and Bi, and from combinations thereof, preferably from P and As. It will be apparent that in this case $Q^B$ is not the same as $Q^A$, or, if $Q^B$ represents a combination of elements, that the combination does not contain $Q^A$. Thus, in the particularly preferred case where $Q^A$ is P, it is preferred that $Q^B$, if present, is selected from As, Sb and Bi, and from combinations thereof. As will be understood by the skilled reader, the optional element(s) $Q^B$ replace the element $Q^A$ in the compound in accordance with the invention by occupying sites in the crystal structure which would otherwise be occupied by $Q^A$ in the absence of $Q^B$. The ratio of the optional element(s) $Q^B$ is defined by the index z in formula (Ia), which is 0 (i.e. element(s) $Q^B$ are absent) to 0.50 (i.e. a maximum of 50 % of the sites in the crystal structure which would be occupied by the element $Q^A$ can be occupied by $Q^B$). Preferably, z is 0 to 0.15, more preferably 0 to 0.05.

Thus, in the compounds in accordance with the invention, it is generally preferred that x, y and z are 0 to 0.15, and more preferred that x, y and z are 0 to 0.05. Moreover, it is generally preferred that at least one of x, y and z is 0 (i.e. at least one of $M^B$, $X^B$ and $Q^B$ is absent), and more preferred that at least two of x, y and z are 0. Most preferably, y and z are 0.

As noted above, the present invention also provides compounds containing elements from group 13 or 16 of the periodic table as dopant elements which are present in small amounts to modify the electronic structure, e.g. to increase the mobility of the charge carriers of the compound of formula (Ia). Thus, the invention also provides a doped variant of the compound of formula (Ia), which further contains:

(i) an element $M^D$, selected from Al, Ga, In and from combinations thereof, in a maximum amount of 10 mol% based on the total molar amount of $M^A$ and $M^B$, which element $M^D$ may partially replace $M^A$ and/or $M^B$ in formula (Ia); and/or

(ii) an element $Q^D$, selected from S, Se, Te and from combinations thereof, in a maximum amount of 10 mol% based on the total molar amount of $X^A$, $X^B$, $Q^A$ and $Q^B$, which element $Q^D$ may partially replace $X^A$, $X^B$, $Q^A$ and/or $Q^B$ in formula (Ia).

To that extent, the doped variants of the compound of formula (Ia) provided by the present invention can be represented by the following formula (Ib):

$$M^A_{1-x}M^B_xX^A_{1-y}X^B_yQ^A_{1-z}Q^B_z{:}(M^D, Q^D) \qquad \text{(Ib)},$$

wherein $M^A$, $M^B$, $X^A$, $X^B$, $Q^A$, $Q^B$, $M^D$, $Q^D$, x, y and z, and the amount of $M^D$ and of $Q^D$ are as defined above, including all preferred embodiments, and the notation of $M^D$ and $Q^D$ in brackets after the colon in the formula indicates that either $M^D$, or $Q^D$, or a combination of $M^D$ and $Q^D$ are present as dopant in the compound of the formula $M^A_{1-x}M^B_xX^A_{1-y}X^B_yQ^A_{1-z}Q^B_z$.

The doped variant of the compound of formula (Ia) consists of $M^A$, optionally $M^B$, $X^A$, optionally $X^B$, $Q^A$, and optionally $Q^B$, together with $M^D$ and/or $Q^D$. It is preferred for the doped variant that $M^D$ and $Q^D$ are not present simultaneously in the same compound, i.e. that either $M^D$ or $Q^D$ is contained. These preferred doped variants can be represented by formulae (Ic) and (Id):

$$M^A_{1-x}M^B_xX^A_{1-y}X^B_yQ^A_{1-z}Q^B_z{:}M^D \qquad \text{(Ic)},$$

$$M^A_{1-x}M^B_xX^A_{1-y}X^B_yQ^A_{1-z}Q^B_z{:}Q^D \qquad \text{(Id)},$$

wherein $M^A$, $M^B$, $X^A$, $X^B$, $Q^A$, $Q^B$, $M^D$, $Q^D$, x, y and z, and the amount of $M^D$ and of $Q^D$ are as defined above, including all preferred embodiments.

In terms of a convenient synthesis of the compounds in accordance with the invention, it is preferred that $M^B$ and $M^D$ are not present simultaneously in the doped variant of the compound in accordance with the invention, i.e. that x is 0 when $M^D$ is present. Similarly, it is preferred that $X^B$ or $Q^B$ and $Q^D$ are not present simultaneously, i.e. that y and z are 0 when $Q^D$ is present.

It is more preferred for the doped variant that $M^B$, $X^B$ and $Q^B$ are not present. Thus, particularly preferred as the doped variant of the compound in accordance with the invention are a compound consisting of $M^A$, $X^A$, $Q^A$ and $M^D$ and a compound consisting of $M^A$, $X^A$, $Q^A$ and $Q^D$. These particularly preferred doped variants can be represented by formulae (Ie) and (If):

$$M^AX^AQ^A{:}M^D \qquad \text{(Ie)},$$

$$M^A X^A Q^A : Q^D \qquad (If),$$

wherein $M^A$, $X^A$, $Q^A$, $M^D$, and $Q^D$ are as defined above, including all preferred embodiments.

In the doped variant of the compound in accordance with the invention, it is preferred that $M^D$, if present, replaces $M^A$ and/or $M^B$ in the compound of formula (Ia) by occupying sites in the crystal structure of the compound of formula (Ia) which would be occupied by $M^A$ and optionally $M^B$ in the absence of $M^D$. Similarly, it is preferred that $Q^D$, if present, replaces $X^A$, $X^B$, $Q^A$, and/or $Q^B$ in the compound of formula (Ia) by occupying sites in the crystal structure of the compound of formula (Ia) which would be occupied by $X^A$, $X^B$, $Q^A$ and/or $Q^B$ in the absence of $Q^D$. Such a replacement is also preferred for the compounds of formulae (Ib) to (If), where $M^D$ would replace sites occupied by $M^A$ and/or $M^B$ in the structure indicated before the colon, and/or $Q^D$ would replace sites occupied by $X^A$, $X^B$, $Q^A$ and/or $Q^B$ in the structure indicated before the colon.

The element $M^D$ is present in a maximum amount of 10 mol% based on the total molar amount of $M^A$ and $M^B$ in the doped variant of the compound of formula (Ia), including the preferred formulae of the doped variant illustrated above. Preferably, $M^D$ is present in a maximum amount of 5 mol%, and more preferably in a maximum amount of 1 mol%. The element $Q^D$ is present in a maximum amount of 10 mol% based on the total molar amount of $X^A$, $X^B$, $Q^A$ and $Q^B$ in the doped variant of the compound of formula (Ia), including the preferred formulae of the doped variant illustrated above. Preferably, $Q^D$ is present in a maximum amount of 5 mol%, and more preferably in a maximum amount of 1 mol%.

In a preferred embodiment, the compounds in accordance with the present invention are compounds of the following formula (II). As will be appreciated, formula (II) encompasses compounds of formula (Ia) as well as doped variants thereof.

$$(M^A_{1-x}M^B_x)_{1-3m}M^D_{2m}X^A_{1-y}X^B_y(Q^A_{1-z}Q^B_z)_{1-2n}Q^D_n \qquad (II),$$

In formula (II) $M^A$, $M^B$, $X^A$, $X^B$, $Q^A$, $Q^B$, $M^D$, $Q^D$, x, y and z are defined as for formula (Ia) and for the doped variant thereof, including all preferred definitions, i.e.:

$M^A$  is an element selected from Si, Ge, Sn, and Pb, ,

$M^B$  is an element selected from Si, Ge, Sn, and Pb and from combinations thereof, such that $M^B$ is not the same as $M^A$ and does not contain $M^A$, and

x  is 0 to 0.50, preferably 0 to 0.15, and more preferably 0 to 0.05;

$X^A$  is an element selected from F, Cl, Br and I,

$X^B$  is an element selected from F, Cl, Br and I and from combinations thereof such that $X^B$ is not the same as $X^A$ and does not contain $X^A$, and

y  is 0 to 0.50, preferably 0 to 0.15, and more preferably 0 to 0.05;

$Q^A$  is an element selected from P, As, Sb and Bi,

$Q^B$  is an element selected from P, As, Sb and Bi and from combinations thereof such that $Q^B$ is not the same as $Q^A$ and does not contain $Q^A$,

z  is 0 to 0.50, preferably 0 to 0.15, and more preferably 0 to 0.05;

$M^D$  is an element selected from Al, Ga and In and from combinations thereof,

$Q^D$  is an element selected from S, Se and Te and from combinations thereof, and

m  is 0 to 0.03, preferably 0 to 0.01, and more preferably 0 to 0.005; and

n  is 0 to 0.1, preferably 0 to 0.05, more preferably 0 to 0.01, and most preferably 0 to 0.005.

Also for the compounds of formula (II), it is preferred that $M^A$ is selected from Ge, Sn and Pb, and is more preferably Sn. $M^B$, if present, is preferably selected from Ge, Sn and Pb and from combinations thereof, and is more preferably Pb. $X^A$ is preferably selected from Br and I, and is particularly preferably I. $X^B$, if present, is preferably selected from Br and I. $Q^A$ is preferably selected from P and As, and is particularly preferably P. $Q^B$, if present, is preferably selected from P and As.

Thus, in the compounds in accordance with the invention, it is generally preferred that x, y and z are 0 to 0.15, and more preferred that x, y and z are 0 to 0.05. Moreover, it is generally preferred that at least one of x, y and z is 0 (i.e. at least one of $M^B$, $X^B$ and $Q^B$ is absent), and more preferred that at least two of x, y and z are 0. Most preferably, y and z are 0.

Also for the compounds of formula (II), it is generally preferred that at least one of x, y and z is 0 (i.e. at least one of $M^B$, $X^B$ and $Q^B$ is absent), and more preferred that at least two of x, y and z are 0. Most preferably, y and z are 0.

Preferably, m and n should not both be > 0 in the same compound, i.e. at least one of m and n should be 0. However, it may be beneficial for certain applications if different compounds in accordance with the invention are combined, e.g. to form separate regions within a device, wherein m > 0 and n = 0 and wherein n > 0 and m = 0.

Moreover, in terms of a convenient synthesis of the compounds in accordance with the invention, it is preferred that $M^B$ and $M^D$ are not present simultaneously, i.e. that at least one of m and x in formula (II), and where applicable in the preferred formulae, is 0. Similarly, it is preferred that $Q^B$ and $Q^D$ are not present simultaneously, i.e. that at least one of n and z in formula (II), and where applicable in the preferred formulae, is 0.

As will be understood by the skilled reader, the indices 1-x, x, 1-y, y, 1-z, z, 1-3m, m, 1-2n, and n indicate the stoichiometry of the elements in the concerned compound. Thus, if a value of 0 is indicated for x, y, z, m or n, the element carrying the concerned index is not contained in the compound. In the compounds of the invention which do not contain a dopant element $M^D$ or $Q^D$, the stoichiometric ratio of component $M^A$ (and optionally $M^B$), component $X^A$ (and optionally $X^B$), and component $Q^A$ (and optionally $Q^B$), respectively, is 1:1:1. Thus, equimolar amounts of the components may be determined, typically within a deviation of not more than $\pm$ 10%, preferably not more than $\pm$ 5% for each component, taking into account the error margins resulting from unavoidable practical limitations in the precision of synthetic and analytic techniques. This stoichiometric ratio may be shifted to values of < 1 for $M^A$ (and optionally $M^B$) if $M^D$ is present and partially replaces $M^A$ and/or $M^B$, or to values < 1 for $X^A$ (and optionally $X^B$) and/or values < 1 for $Q^A$ (and optionally $Q^B$) if $Q^D$ is present and partially replaces $X^A$ and optionally $X^B$ and/or $Q^A$ and optionally $Q^B$.

In line with the above and in accordance with preferred embodiments, the present invention provides compounds of formulae (IIIa), (IIIb), (IIIc) or (IIId):

$$M^A_{1-3m}M^D_{2m}X^A(Q^A_{1-z}Q^B_z)_{1-2n}Q^D_n \qquad \text{(IIIa)},$$

$$M^A_{1-3m}M^D_{2m}X^A_{1-y}X^B_yQ^A_{1-2n}Q^D_n \qquad \text{(IIIb)},$$

$$(M^A_{1-x}M^B_x)_{1-3m}M^D_{2m}X^AQ^A_{1-2n}Q^D_n \qquad \text{(IIIc)},$$

$$M^A_{1-3m}M^D_{2m}X^AQ^A_{1-2n}Q^D_n \qquad \text{(IIId)},$$

wherein $M^A$, $M^B$, $M^D$, $X^A$, $X^B$, $Q^A$, $Q^B$, x, y, z, m and n are defined as for formula (II), including the preferred embodiments.

In accordance with additional preferred embodiments, the present invention provides compounds of formulae (IVa), (IVb), (IVc) or (IVd):

$$M^AX^A(Q^A_{1-z}Q^B_z) \qquad \text{(IVa)},$$

$$M^A(X^A_{1-y}X^B_y)Q^A \qquad \text{(IVb)},$$

$$(M^A_{1-x}M^B_x)X^AQ^A \qquad \text{(IVc)},$$

$$M^AX^AQ^A \qquad \text{(IVd)},$$

wherein $M^A$, $M^B$, $X^A$, $X^B$, $Q^A$, $Q^B$, x, y, and z are defined as for formula (II), including the preferred embodiments.

Preferred specific compounds in accordance with the invention can be selected from GeIP, GeBrP, GeClP, GeFP, GeIAs, GeBrAs, GeClAs, GeFAs, SnIP, SnBrP, SnClP, SnFP, SnIAs, SnBrAs, SnClAs, SnFAs, SnISb, SnBrSb, SnClSb, SnFSb, PbIP, PbBrP, PbClP, PbFP, PbIAs, PbBrAs, PbClAs, PbFAs, PbIBi, PbBrBi, PbClBi, and PbFBi, and more preferred specific compounds from GeIP, GeIAs, SnIP, SnBrP, SnClP, PbIP, PbBrP and PbClP. Particularly preferred is SnIP.

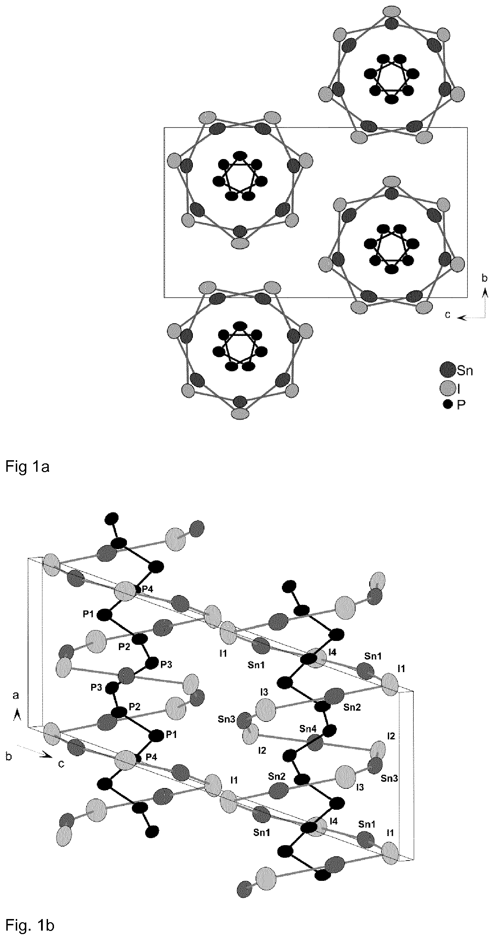

As indicated above, the compounds in accordance with the present invention are characterized by a crystal structure wherein the constituting atoms are arranged in the form of a double helix. In particular, two substructures can be identified in the crystalline compounds in accordance with the invention: a first, inner helical chain formed by a plurality of atoms of the element $Q^A$ is surrounded by a second helical chain formed by a plurality of alternating atoms $M^A$ and $X^A$. The first inner helix can also be described as $^1_\infty[Q^{A-}]$, the second helical chain as $^1_\infty[(M^AX^A)^+]$. This structure is illustrated in Fig. 1a and b for the exemplary compound SnIP. Formal oxidation states of $(M^A)^{2+}$, $(X^A)^-$ and $(Q^A)^-$ can be assigned, such that the two helices are attracted to each other by the formal negative charges of the inner helix and the positive (net) charges of the surrounding helix. The resulting structure can also be referred to as a nanotube, with the double helix forming the tube wall. As explained above, the optional elements $M^B$, $M^D$, $X^B$, $Q^B$ and/or $Q^D$ can be incorporated to replace a part of the corresponding elements $M^A$, $X^A$ and/or $Q^A$ at their respective position in the double helix.

The diameter of the double helix or nanotube of the compounds in accordance with the invention is in the nanometer range, typically in the range of 0.5 to 10 nm, preferably 0.9 to 3 nm, and has been determined as 0.98 nm for the exemplary compound SnIP. The attractive bonds between the nanotubes have been found to be relatively weak van der Waals like bonds, such that the single nanotubes, or nanobundles combining a number of nanotubes, e.g. 2 or more, preferably 5 or more, and 100 or less, preferably 70 or less, can be conveniently provided. The convenient and efficient delamination of the compounds in accordance with the invention resulting from the double-helix structure, is a pronounced advantage since the provision of materials in the nanometer range usually involves laborious separation processes after synthesis.

As a result, the compounds of the present invention can be advantageously used to provide micro- or preferably nanomaterials. A micro- or nanomaterial in accordance with the invention comprises, and preferably consists of a compound in accordance with the invention. In this context, the term "micromaterial" refers to a material in a form where the smallest dimension is in the micrometer range. As an example, a microfiber can be mentioned, with a diameter in the micrometer range and a length of up to several mm, such as up to 5 mm. The term "nanomaterial" refers to a material in a form where at least one dimension is in the nanometer range. Preferred nanomaterials in the context of the invention are nanotubes or nanowires which comprise, or preferably consist of a compound in accordance with the invention. The term "nanowire" as a generic term is intended to encompass single nanotubes as well as bundles of nanotubes with an overall diameter in the nanometer range. For a nanowire, the diameter as the smallest dimension will be in the nanometer range, whereas the length of the nanowire can be substantially larger. With a view to their shape, the nanowires can alternatively be referred to as "nanofibers". However, due to the electronic properties of the compounds in accordance with the invention, and their suitability as semiconducting materials, the term "nanowire" was given preference. Further nanomaterials comprising or preferably consisting of one or more compounds in accordance with the invention are nanoparticles, where all dimensions are in the nanometer range.

Unless indicated otherwise in a specific context, the micrometer range as referred to herein is typically the range of > 100 nm to 100 $\mu$m, preferably 500 nm to 100 $\mu$m. Unless indicated otherwise in a specific context, the nanometer range as referred to herein is typically the range of 0.5 to 100 nm, preferably 0.7 to 50 nm.

Thus, in a particularly preferred aspect the present invention provides nanowires as elongated structures with a diameter in the nanometer range of typically 0.5 to 100 nm, preferably 0.7 to 50 nm, more preferably 0.7 to < 20 nm and most preferably 0.7 to < 10 nm, and a length of typically more than 100 nm, preferably more than 1 $\mu$m, and more preferably more than 10 $\mu$m. The upper limit of the length is not particularly restricted, but for most applications a length of up to 1 mm will be sufficient. In this context, it will be understood that the reference to the diameter of the nanowire relates to the diameter perpendicular to the longest axis of the nanowire, which diameter can be determined, e.g., from microphotographs. The nanowires provided in the context of the invention generally show uniform diameters, such that the diameter of a nanowire in accordance with the invention typically remains in the nanometer range along the whole length of the nanowire. If nevertheless a certain variation in the diameter is observed, the maximum diameter should be used as the representative value for the diameter, e.g. for the calculation of the aspect ratio. The aspect ratio, i.e. the ratio of the length of the nanowire to the diameter of the nanowire, is typically more than 100, and preferably more than 500. The upper limit of the aspect ratio is not particularly restricted, and nanowires with aspect ratios of up to 5000 can be conveniently provided using the synthetic methods described herein. However, generally an aspect ratio of 2000 or less, for most applications an aspect ratio of 1000 or less will be sufficient for the nanowires in accordance with the invention. The nanowires comprise a compound in accordance with the invention, and preferably consist of a compound in accordance with the invention, i.e. the compound is provided in the form of a nanowire.

Also encompassed as micro- or nanomaterials by the present invention are films comprising or consisting of the nanotubes or nanowires or both in accordance with the invention. The films are preferably nanofilms, i.e. films with a thickness in the nanometer range. The films can be supported by a carrier, but can also be self-supporting.

The compounds of the invention provide electronic properties which allow them to be used as semiconductors. For example, quantum chemical calculations (LDA functionals) on the exemplary compound SnIP yielded a band gap of 1.22 eV for the bulk material and a band gap of 1.29 eV for a single, non-coordinated nanotube. It will be understood that the electronic properties of the compounds of the invention can be tailored for diverse applications using different starting materials and/or dopants. Thus, the compounds and the micro- or nanomaterials of the invention can be advantageously used in electrical, electronic, optical, or optoelectronic devices, or as photocatalysts.

Moreover, the compounds in accordance with the invention have been found to yield materials with extraordinary stability in terms of a high mechanical flexibility and elasticity. Even a crystalline microfiber formed from a compound in accordance with the invention and having a length of 1-2 mm and a thickness of several $\mu$m could be bent by 180° and returned to its original shape without visible deformation. Without wishing to be bound by theory, it is assumed that this is the result of the double-helix structure assumed by the constituting atoms of the compounds in accordance with the invention. Due to this flexibility, the compounds and the micro- or nanomaterials of the invention can be advantageously used in flexible devices, in particular flexible electrical, electronic, optical, or optoelectronic devices, such as solar cells, displays or sensors.

It will be appreciated that the definitions of the elements $M^A$, $M^B$, $X^A$, $X^B$, $Q^A$, $Q^B$, $M^D$ and $Q^D$ from which the compounds in accordance with the invention are formed encompass elements with little or no toxicity such as Sn, I or P, which may also be an advantage in applications of these compounds.

The properties discussed above can be exploited in a variety of applications of the compounds or of the micro- or nanomaterials in accordance with the invention, in particular of the nanowires. Thus, the invention also encompasses the use of a compound or of a micro- or nanomaterial, in particular a nanowire, in accordance with the invention as a semiconductor, in particular as a semiconductor in an electrical, electronic, optical, or optoelectronic device. It also encompasses an electrical, electronic, optical, or optoelectronic device comprising a compound or a micro- or nanomaterial, in particular a nanowire, in accordance with the invention. As noted above, the device may advantageously be a flexible device, or at least comprise a flexible part in which in the compound or the micro- or nanomaterial, in particular the nanowire, in accordance with the invention is present.

Preferred as an electrical, electronic, optical, or optoelectronic device are devices for the conversion of energy, in particular the conversion of electromagnetic waves in the UV, visible or infrared region into electric energy, e.g. a solar cell, or a thermoelectric device. Further preferred devices are a sensor, or a display or screen.

Solar cells commonly used for energy conversion are typically based on polycrystalline silicon. The compounds or the micro- or nanomaterials in accordance with the invention, such as SnIP, are particularly useful e.g. for the provision of linear nanostructured solar cells (cf. X. Wang, K. L. Pey, C. H. Yip, E. A. Fitzgerald, D. A. Antoniadis, J. Appl. Phys. 2010, 108, 124303; or D. T. Moore, B. Gaskey, A. Robbins, T. Hanrath, J. Appl. Phys. 2014, 115, 054313) or quantum-dot solar cells (G. Konstantatos, E. H. Sargent, Colloidal Quantum Dot Optoelectronics and Photovoltaics, Cambridge press, ISBN 978-0-521-19826-4). As explained above, the compounds in accordance with the invention can be used e.g. to fabricate thin film and flexible devices. Preferred are nanowires with diameters of < 10 nm and providing high aspect ratios of e.g. more than 1000. By self-assembling processes, a high aspect ratio can be of benefit to assemble thin film solar cells with parallel or random arrangement of such wires. For example SnIP, with a calculated band gap of 1.2 - 1.3 eV (1.2 eV as microcrystalline material and 1.3 eV for nanowires) can provide solar cells with an extraordinary efficiency.

In thermoelectric materials and devices, a commonly used strategy for the optimization of the performance is the reduction of thermal conductivity by the generation or incorporation of phonon scattering, nanostructured materials. The efficiency of such systems can be systematically increased by such a process (B. Sothmann, R. Sánchez, A. N. Jordan, Nanotechnology 2015, 26, 032001 (23p)). Figure of merits larger than 2 have been achieved, pushing the efficiency of such systems in applicable regions. Due to the flexible adjustment of sizes for the compounds in accordance with the invention from micrometers down to 1 nm, an effective phonon scattering is possible. This feature can significantly increase the figure of merit of thermoelectrics. Thus, using the compounds or the micro- or nanomaterials in accordance with the invention, such as SnIP with a defined nanostructure < 10 nm, performances in the same region or even better can be expected. For example, self-organized bulk and thin layer devices are possible, representing high-quality quantum structures. Moreover, the compounds or the micro- or nanomaterials in accordance with the invention can be used in organic-inorganic hybrid thermoelectric materials and devices. For this purpose, the compounds in accordance with the invention, in particular in the form of nanowires, can be embedded in an electrically conductive polymer (e.g. a thiophen-based polymer) in different dimensions within the diameter range of 1 nm (e.g. single nanotubes) to 100 nm (e.g. bundles of nanotubes or nanowire). Consequently, the efficient phonon scattering based on the known panoscopic principle found with PbTe@Na@SrTe (K. Biswas, et al., Nature 2012, 489, 414-418) is possible due to scattering on particles of different sizes.

As far as sensors are concerned, the continuous reduction of size down to the nanoscale leads to an increase in efficiency in sensor applications. The present invention provides a simple and effective strategy to implement nanoscale structures in the form of the nanomaterials discussed herein, including sizes at the lower end of the nanometer range (e.g. 1 to 10 nm). State of the art approaches for the formation of particles in this size range, such as template syntheses, e.g. for the formation of GaN nanotubes, for senor applications (J. Goldberger, R. Fan, P. Yang, Acc. Chem. Res. 2006, 39, 239) are considerably more complex. Moreover, nanoparticular gold and silver are proposed for heavy metal detection (S. Su, W. Wu, J. Gao, J. Lu, C. Fan, J Mater. Chem. 2012, 22, 18101). The compounds in accordance with the invention are comparatively abundant and cheap elements.

Optical devices are known based on systems containing Zn, Cd, Pb and Hg-Selenides. One-dimensional nanotubes formed by CdTe are produced by a so called capping synthesis (Z. Tang, N. A. Kotov, M. Giersing, Science 2002, 297, 237-240). Nano imprinting is a method for the fabrication of metallic glasses down to 10 nm diameter and large aspect ratios (G. Kumar, H. X. Tang, J. Schroers, Nature 2009, 457, 868-872). The compounds in accordance with the invention make smaller nanomaterials accessible (down to 1 nm) with comparable or larger aspect ratios.

Furthermore, the invention also encompasses the use of a compound or of a micro- or nanomaterial in accordance with the invention as a photocatalyst, such as a photocatalyst for the splitting of water into hydrogen or oxygen. The compounds of the invention are water stable, and can be provided in the form of semiconductors with a band gap suitable for photocatalysis (e.g. SnIP). Their size can be suitably adjusted on the micrometer or nanometer scale, and elements can be used for which no environmental problems or issues in a recycling procedure will arise.

The present invention also provides a process for the preparation of the compounds in accordance with the invention, and a method for the preparation of the micro- or nanomaterials in accordance with the invention.

The compounds in accordance with the invention can be conveniently synthesized by reacting suitable starting materials, e.g. in an annealing reaction. Such a reaction is typically carried out at high temperatures, and the reactions conditions will be discussed in further detail below.

The starting materials can be selected, e.g., from (i) the elements contained in the compound, i.e. $M^A$, optionally $M^B$, $X^A$, optionally $X^B$, $Q^A$, optionally $Q^B$, optionally $M^D$ and optionally $Q^D$ in elemental form, (ii) precursor compounds formed from elements contained in the compound, typically two or more of these elements, e.g. metal halogenides formed from $M^A$, $M^B$, or $M^D$, and $Q^A$, $Q^B$, or $Q^D$, and (iii) from combinations of (i) and (ii). Prior to the reaction, the starting materials are typically mixed in the desired stoichiometric amounts, i.e., in relative amounts that reflect their stoichiometric ratio in the compound to be prepared. As will be understood by the skilled person, these stoichiometric amounts are defined by the formula of the compound to be prepared, in particular formulae (Ia)-(If), (II), (IIIa)-(IIId) and (IVa)-(IVd). After mixing, they may be compressed to facilitate the reaction. Subsequently, the mixed starting materials are typically sealed in a vessel, e.g. a silica glass vessel such as an ampoule. The vessel should preferably be dried, e.g. by keeping it at temperatures above 100°C. Where necessary, it can be washed prior to being charged with the starting materials, e.g. with an organic solvent having a low boiling point like acetone. Then, the starting materials are reacted under heat. During the reaction, the starting materials are kept in an inert atmosphere, i.e. an atmosphere from which gases that could react with the starting materials under the desired reaction conditions have been removed or replaced, preferably an atmosphere not containing such gases. As used herein, an inert atmosphere includes a vacuum as a preferred option, typically with a pressure of less than 1 Pa.

The reaction of the starting materials is carried out under heat, e.g. at temperatures in the range of 623 to 1073 K. For compounds wherein $M^A$ and, if present $M^B$, is Ge, Sn, and/or Pb, the temperature is preferably 643 to 923 K, more preferably 653 to 793 K. For compounds containing Si, reaction temperatures in the range of 823 to 1073 K are preferred. Reaction times are typically in the range of hours to days, such as 5 h to 18 days. For compounds wherein $M^A$ and, if present $M^B$, is Ge, Sn, and/or Pb, the reaction time is preferably 5 h to 5 days, more preferably 5 h to 15 h for Sn and Pb compounds and of 3 to 5 days for Ge compounds. For compounds containing Si, longer reaction times may be useful, e.g. from 15 to 18 days. If the compounds contain, in addition to $M^A$, also $M^B$, and/or $M^D$, or if the compounds contain, in addition to $Q^A$, also $Q^B$, and/or $Q^D$, the preferred reaction temperatures are the same as for the non-substituted phases, but longer reaction times e.g. in the range of 6 to 8 days may be useful.

After the reaction, the cooling rate can be controlled to control the growth of crystals of the compounds in accordance with the invention. For example, cooling rates in the range of 5 K/h to 1 K/h may be applied, generally until the product reaches room temperature.

In order to obtain the micro- and nanomaterials in accordance with the invention, in particular the nanowires discussed above, the material yielded by the reaction (also referred to as "bulk material") can be exfoliated, i.e. crystalline entities of the desired size can be separated from the bulk material. The exfoliation can be accomplished e.g. by mechanical or chemical means. Preferred approaches are the removal of crystalline entities, e.g. as single nanotubes or bundles of nanotubes, from the surface of the bulk material via adhesion to an adhesive surface, such as an adhesive tape. Chemical methods may involve the dispersion of the bulk material in a solvent, such as chloroform, dichloromethane, N-methylpyrrolidone or toluene. The dispersion may be assisted by an ultrasonic bath or ultra turrax®.

To that extent, the invention further provides a process for the production of the compound in accordance with the invention, which process comprises the steps of:

> a) mixing starting materials selected from (i) elements contained in the compound, (ii) precursor compounds formed from elements, typically two or more elements, contained in the compound, and (iii) combinations of (i) and (ii), in the desired stoichiometric amounts;
> b) reacting the starting materials under heat in an inert atmosphere; and optionally
> c) exfoliating the obtained material to prepare the compound in the form of a nanowire.

Examples

*Synthesis of SnIP:*

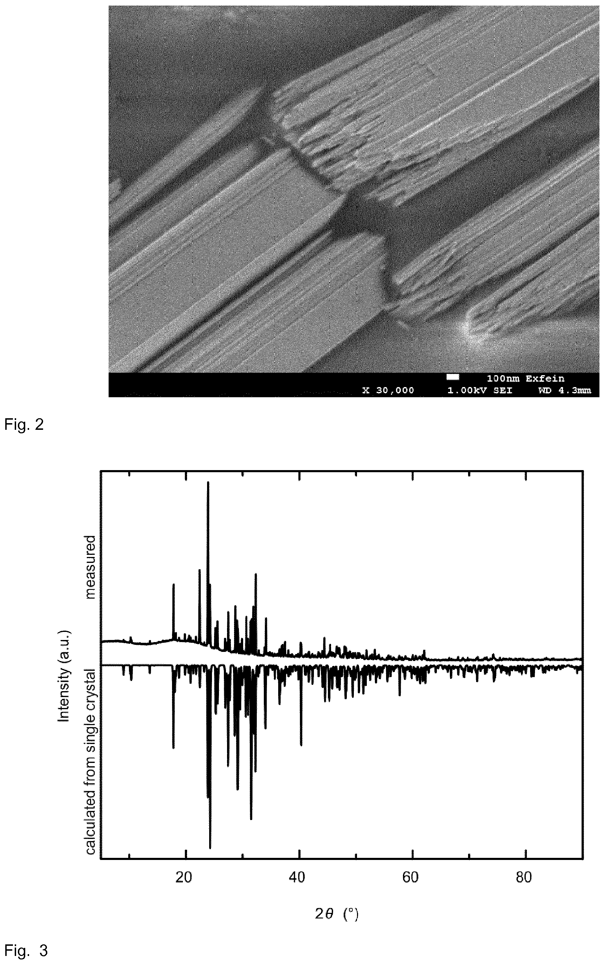

Microcrystalline SnIP was prepared either by reaction of the elements in stoichiometric amounts or by the reaction of Sn, $SnI_4$ and P in evacuated silica ampoule at 673 K. All glassware has been dried at 105° in an oven over night. Each ampoule was washed with acetone prior to the usage. The temperature program is as following: 0.8 K/min heating to 673 K, holding for 10 h and cooling with 5 K/h. Single crystals were prepared by heating Sn, $SnI_4$ and red P (20 mg, 10 mg and 500 mg) up to 923 K (1.3 K/min) in an evacuated silica tube and holding for 5 h. The cooling was done stepwise first with 2 K/h to 773 K, after 15 h it was cooled down to room temperature with a cooling rate of 1.2 K/h. A SEM picture of the obtained microcrystals is shown in Fig. 2.

By exfoliation with common tape, nanosized crystals with a diameter smaller than 40 nm and an aspect ratio of >1000 (aspect ratio: quotient of length to diameter) were prepared. The tape method was applied previously for other 2D materials as graphene. Nano wires of even smaller diameters down to single strand wires were prepared by optimized exfoliation (with tape e.g. "Lensguard 7568" by Nitto) or by dispersing in chloroform.

*Chemical Analysis:*

Elemental analysis shows Sn:P:I 40.0 : 11.26 : 44.2 wt.-%. The theoretical values are: 42.92: 11.2 : 45.88. Energy dispersive X-ray spectroscopy (EDX) has been performed leading to a composition of SnIP of Sn 33(1): P 34(2): I 33(1) at.-%. Theoretical values: 33:33:33 at.-%.

*Structure determination:*

The crystal structure of SnIP (see Figure 1a and 1b) has been determined from a single crystal by X-ray diffraction and has been substantiated by X-ray powder diffraction of a microcrystalline sample. Lattice parameters and selected crystallographic data are: The crystal structure of SnIP: Stoe IPDS II diffractometer, $MoK_\alpha$ radiation, $\lambda$ = 0.71069 Å, T = 293 K, crystal dimensions 0.01 x 0.01 x 0.2 $mm^3$, monoclinic, space group P2/c (No. 13), lattice parameters a = 7.934(2) Å, $b$ = 9.802(3) Å, c = 18.439(9) Å, $\beta$= 110.06(5)°, V = 1347.0(9) $Å^3$, Z = 14. $p$ (calc.) = 4.772 g $cm^{-3}$, $\mu$ ($MoK_\alpha$) = 14.81 $mm^{-1}$, numerical absorption correction, crystal description using X reflections, full matrix least squares refinement on $F^2$ using Jana2006 [Petricek, V., et al., Z. Kristallogr. 2014, 229, 345.], 6796 reflections, 3567 unique ones, $\theta$ max = 29.13°, 98 parameters, $R_{int}$ 0.0859, $R$1 (1651Fo >3$\sigma$(Fo)) = 0.0407, w$R$2 = 0.0840, GoF = 1.02, residual electron density +1.88/-1.98 e $Å^3$.

Bond distances within the helices of $d$(Sn-I) = 3.060(2) to 3.288(3) Å for the tin-iodide helix and of $d$(P-P) = 2.170(4) to 2.211(5) Å for the phosphorus helix were determined. Each chiral single tube is either left or right handed and stacked in an hexagonal rod packed arrangement along the a axis. Tubes of a given chirality are arranged in rows, stacked along the b axis.

Electron localization function (ELF) analysis of SnIP showed the covalent character of the P-P bonds and the strong polarization of the Sn lone pair towards the outer sphere of the tubes. A dative ionic interaction between the two helices can be assumed from the ELF between the Sn and P atoms. Two lone pairs of P are pointing towards the Sn positions creating bond lengths of $d$(Sn-P) = 2.669(3) to 2.708(3) Å. This interaction is comparable to the H-bond system in Deoxyribose Nucleic Acid (DNA),

The purity was substantiated by comparing the single crystal structure data and the measured powder diffractogram (see Figure 3).

*Spectroscopic characterization:*

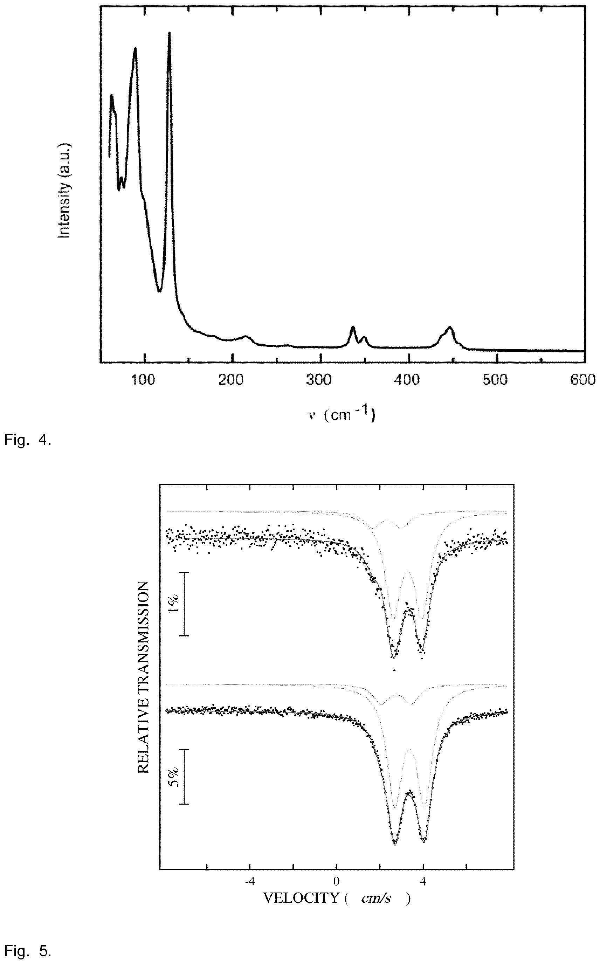

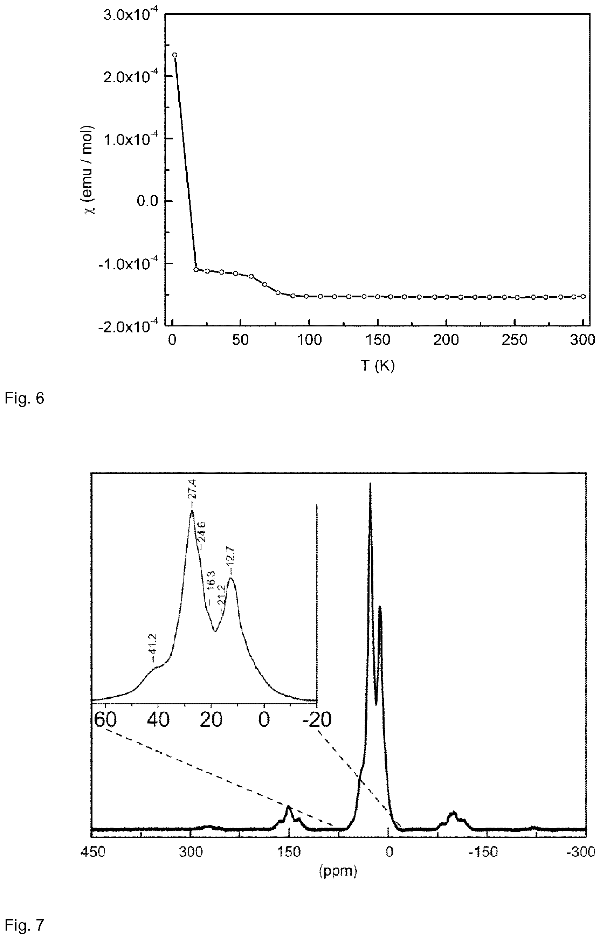

Solid State NMR spectroscopy, Mössbauer spectroscopy and magnetic measurements have been performed, substantiating the crystal structure and oxidation states of Sn in SnIP. It contains $Sn^{2+}$, $I^-$ and $P^-$ (see Figures 4 to 7)

*Exfoliation and dispersion of SnIP:*

Double-helical tubes of SnIP are attracted to each other by van der Waals interactions and can therefore be exfoliated to provide nanotubes or bundles of nanotubes. SnIP was mechanically exfoliated to small bundles of nanotubes by the scotch tape approach. SnIP was fixed between two Nitto "Lensguard 7568" tape foils, the two foils were pressed together and separated afterwards. This process was repeated up to the point when the demanded thickness of the bundles of nanotubes was reached. White light interferometry was used to determine the thickness or diameter of such mechanically exfoliated nanotubes.

Also SnIP nanotubes or bundles of nanotubes were separated via dispersion in organic solvents by the aid of an ultrasonic bath to accelerate the separation process. A summary is given in Table 1. SnIP is not soluble in water.

Table 1: Solubility of SnIP in different solvents. All solutions have been tested for the occurrence of iodide by silver nitrate (formation and crystallization of AgI). + positive; - negative

| | solubility (coloring of solution) | Iodide present | $AgNO_3$/$HNO_3$ |
|---|---|---|---|
| Water | - | - | - |
| Aceton | + (yellow/brown) | + | + |

(continued)

| | solubility (coloring of solution) | Iodide present | $AgNO_3/HNO_3$ |
|---|---|---|---|
| Acetonitril | + (yellow) | + | + |
| Isopropanol | + (pale yellow) | + | + |
| DMF | + (pale yellow) | + | + |
| DMSO | - (pale yellow) | - | - |
| NMP | + (grey, suspension) | - | - |
| Toluol | + (grey, some yellow) | - | - |
| Ethanol | + (yellow) | + | + |
| Chloroform | + (brown suspension) | - | - |
| Dichloromethane | + (brown suspension) | - | - |

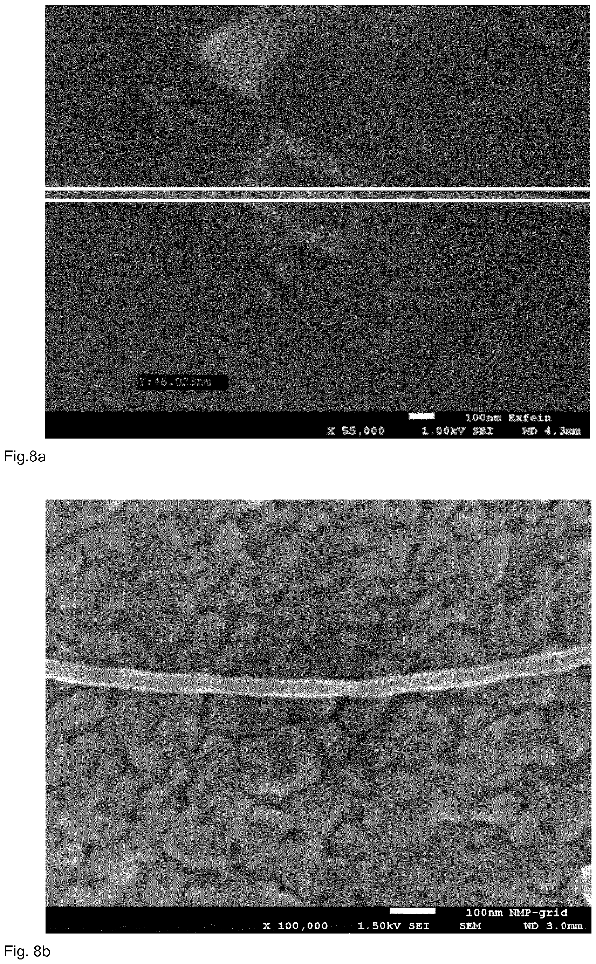

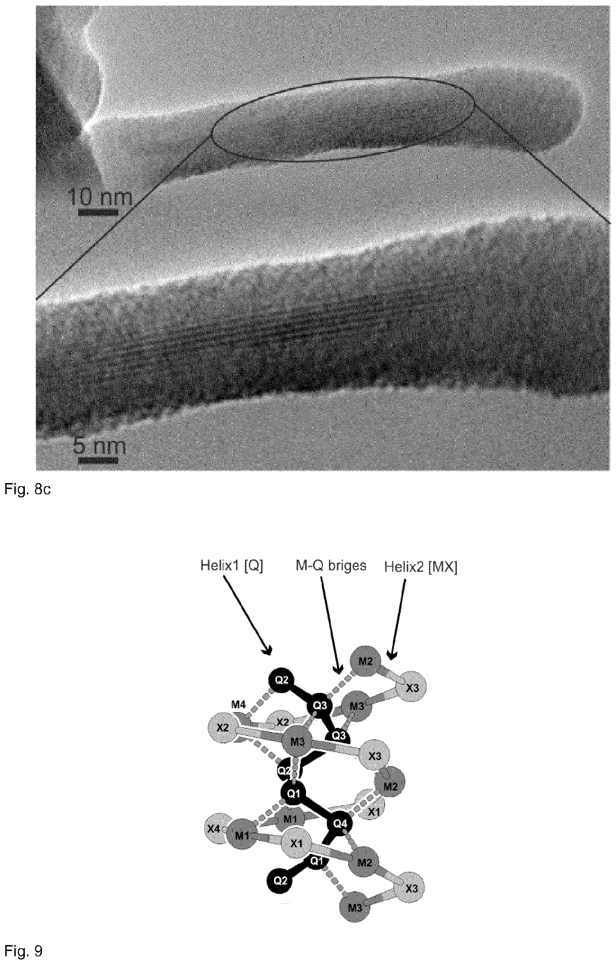

Bundles of nanotubes prepared by these methods are shown in Figs 8a to 8c, showing high resolution SEM pictures of exfoliated SnIP crystals. 8a: Mechanically (tape method) delaminated crystals of 30 nm diameter of SnIP. 8b: Chemically exfoliated SnIP crystal of the same size prepared on a copper grid. 8c: SnIP exfoliated and suspended in chloroform. Coils of SnIP nano tubes with diameters between 5 to 10 nm are provided after evaporation of the solvent.

*Mechanical properties of SnIP:*

Crystals of SnIP show a very high mechanical flexibility and elasticity. Even large crystals of 1-2 mm length and a thickness of some $\mu$m can be bent by 180°. Afterwards, the crystals rearrange without any visible deformation to their original position. This experiment has been performed using a conventional light microscope.

*Electronic properties*

Quantum chemical calculations were performed in the framework of density functional theory (DFT) with LDA and PBE-GGA functionals. To confirm the results, full geometry optimizations were performed with two codes: the projector-augmented-wave (PAW) approach and the conjugant gradient algorithm as implemented in vasp (Kresse G., Furthmüller J., Phys. Rev. B 1996, 54, 11169, Kresse G., Hafner J., J. Phys.: Condens. Matter 1994, 6 8245). Convergence is considered at differences in total energy less than $10^{-5}$ eV and maximum Hellmann-Feynmann forces of $10^{-4}$ eV/Å. Additionally, the all-electron local orbital approach was applied with the Schlegel algorithm as implemented in the program CRYSTAL14 (Dovesi et al. CRYSTAL14 User's Manual. University of Torino: Torino, 2014. Dovesi, R. et al., Int. J. Quantum Chem., 2014, 114, 1287). Thereby, also the Grimme-d2 correction was used to account for dispersion (VdW) interactions.

For bulk-SnIP a band gap of 1.22 eV was observed while a single, non-coordinated SnIP nano tube is characterized by only a slightly larger band gap of 1.29 eV. Due to the determined values SnIP is exactly located in the band gap range of classical semiconductors like Si (ca. 1.1 eV) or GaAs (1.4 eV).

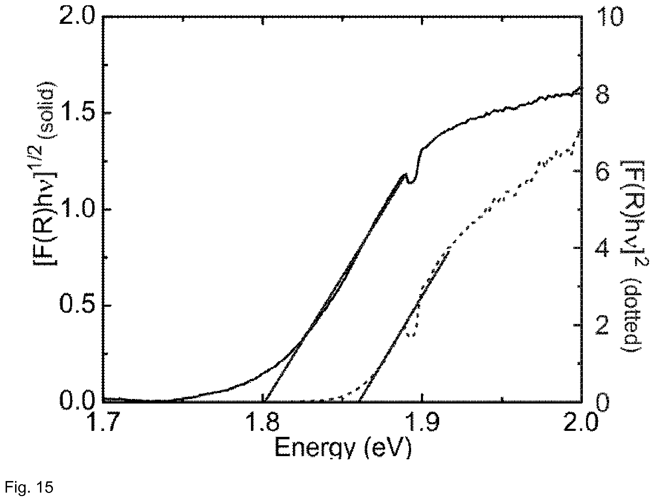

The direct band gap was determined by diffuse reflectance spectroscopy (see Figure 15) to 1.86 eV and the indirect one to 1.80 eV.

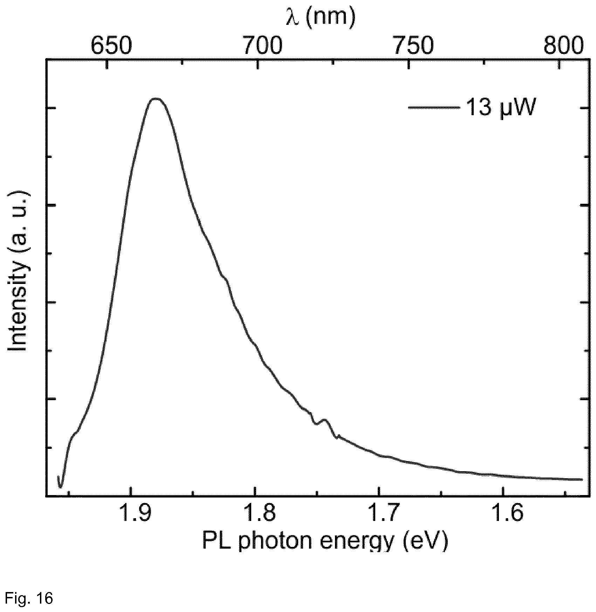

SnIP shows a room temperature photoluminescence with an luminescence maximum at 1.86 eV in perfect accordance to the value determined from diffuse reflectance measurements (Figure 16).

Quantum chemical DFT calculations with the HSE06 functional (J. P. Perdew, Y. Wang, Accurate and simple analytic representation of the electron-gas correlation energy. Phys. Rev. B. 45, 13244-13249 (1992), V. Krukau, O. A. Vydrov, A. F. Izmaylov, G. E. Scuseria. Influence of the exchange screening parameter on the performance of screened hybrid functionals. J. Chem. Phys. 125, 224106 (2006)), a more suitable functional for the determination of the electronic structure (band structure), resulted in a direct band gap of 1.79 eV, in perfect accordance to the measured value.

*Synthesis of GeIP and GeIAs*

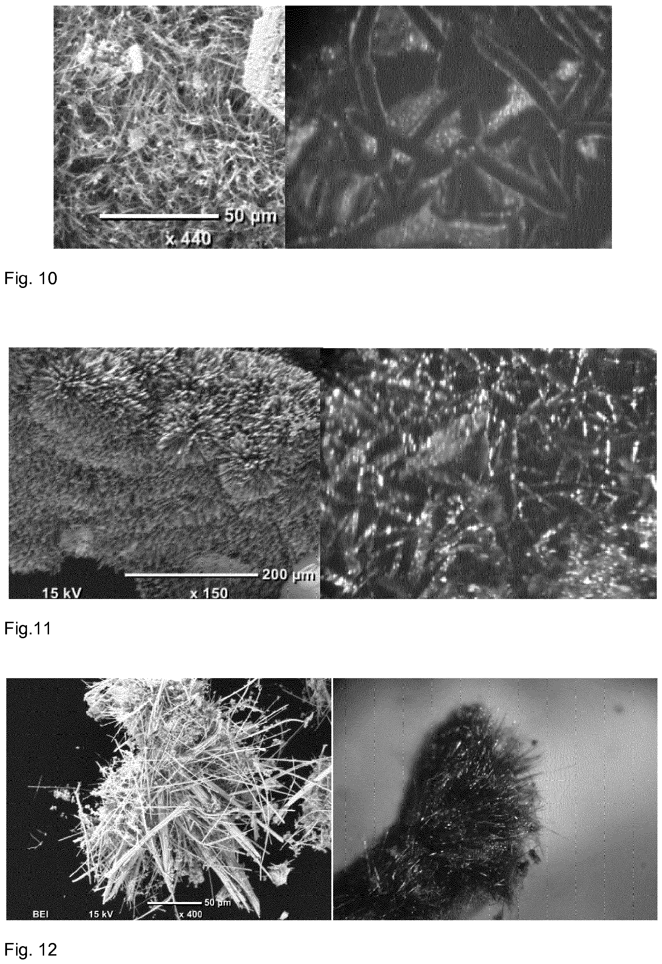

Microcrystalline GeIP and GeIAs were prepared by reactions of the elements in stoichiometric ratio in evacuated silica ampoules at 773 K. All glassware was dried at 105° in an oven over night. Each ampoule was washed with acetone prior to the usage. GeIP: Amounts are 146.2 mg Ge, 255.8 mg $I_2$, and 62.4 mg P; GeIAs: 130.9 mg Ge, 228.9 mg $I_2$ and 135.2 mg As. The temperature program is as follows: in 10 h from room temperature to 773 K, holding the temperature for five days and finally cooling the samples to room temperature within 48 h. Microphotographs of the obtained needle shaped microcrystals are shown in Fig. 10 (GeIP) and 11 (GeIAs).

*Elemental analysis*

Energy dispersive X-ray spectroscopy (EDX) has been performed for GeIP leading to a composition of Ge 28(4) : P 35(4) : I 37(5) at.-%. Theoretical values: 33:33:33 at.-%.

*Synthesis of PbIP and PbBrP*

Microcrystalline PbIP and PbBrP were prepared by reactions of $PbI_2$ or $PbBr_2$ with red phosphorus and lead in stoichiometric ratio in evacuated silica ampoules, in the temperature interval of 643 to 693 K. All glassware has been dried at 105° in an oven over night. Each ampoule was washed with acetone prior to the usage. PbIP: Amounts are 40.0 mg P, 297.8 mg $PbI_2$, and 133.7 mg Pb; PbBrP: 40.3 mg P, 236.4 mg $PbBr_2$, and 133.6 mg Pb. The temperature program is as follows: in 8 h from room temperature to the target temperature, holding the temperature for 10 h and finally cooling the samples to room temperature within 75 h. Microphotographs of the obtained needle shaped microcrystals are shown in Fig. 12 (PbIP) and 13 (PbBrP).

*Elemental analysis*

Energy dispersive X-ray spectroscopy (EDX) has been performed for PbIP and shows Pb 34(1) : P 35(1) : I 31(3) at.-%. Theoretical values: 33:33:33 at.-%.

*Synthesis of $Sn_{0.5}Pb_{0.5}IP$*

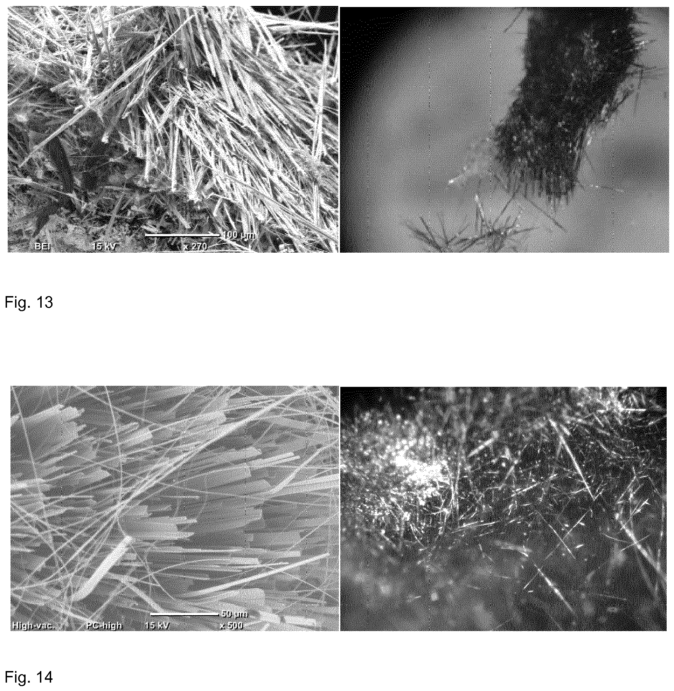

Microcrystalline $Sn_{0.5}Pb_{0.5}IP$ were prepared by reactions of $PbI_2$, Sn and red phosphorus in stoichiometric ratio in evacuated silica ampoules, in the temperature interval of 643 to 693 K. All glassware has been dried at 105° in an oven over night. Each ampoule was washed with acetone prior to the usage. 39.9 mg P, 76.9 mg Sn, 297.3 mg $PbI_2$ were reacted to result in $Sn_{0.5}Pb_{0.5}IP$. The temperature program is as following in 10 h from room temperature to the target temperature, holding the temperature for 10 h and finally cooling the samples to room temperature within 75 h. Microphotographs of the obtained needle shaped microcrystals are shown in Fig. 14.

*Calculated isotypic structures*

The effects of substitution of the elements in isotypic compounds MXQ were estimated from DFT calculations. Assuming structures that are isotypic to experimentally found SnIP all structural parameters were relaxed. Predicted structures are summarized in Table 2. According to the results (1) the structure of SnIP is preserved for all substitutions, (2) the elements M and X have a systematic effect on lattice parameters a, b, c, and β, (3) the substitutions have a systematic effect on the electronic band gap. Conclusion (1) is underlined by the fact that the P substructure is maintained and all P-P distances are found in the range between 2.17 and 2.20 Å upon substitution - similar to SnIP (all further atomic distances are summarized in Table 3 according to the description of Fig. 9). Estimating Vegard's law for partial substitution $Sn_{1-x}M_xI_{1-x}X_xP$ expected lattice parameters are obtained from SnIP by linear interpolation to the respective compound for full substitution MXP. (Hint on the applied method - DFT-LDA slightly underestimates bond lengths and lattice parameters by 1-3%). From the lattice parameter effects (2) upon substitution we expect tunable mechanical properties. The same is predicted for electronic and optic properties from changes of the electronic band structure.

Table 2: Predicted lattice parameters from DFT calculations for completely substituted compounds MXQ for M = Pb, Sn, Ge, Si, X = F, Cl, Br, I, Q = P. An error of +/- 5 % for each value must be taken into account.

| *M* | *X* | *Q* | *a*/Å | *b*/Å | *c*/Å | *β*/° | *V*/Å³ | *ρ*/gcm⁻³ | *ΔEg*/eV |
|-----|-----|-----|-------|-------|-------|-------|--------|-----------|----------|
| Pb | I | P | 8.11 | 9.63 | 18.82 | 109.73 | 1310.3 | 6.48 | 1.32 |
| Sn | I | P | 7.84 | 9.57 | 17.96 | 110.31 | 1257.8 | 5.11 | 1.22 |
| Ge | I | P | 7.50 | 9.26 | 17.30 | 110.31 | 1126.8 | 4.76 | 1.50 |
| Si | I | P | 7.26 | 9.19 | 17.30 | 110.36 | 1081.0 | 4.00 | 1.16 |
| Pb | Br | P | 8.17 | 8.97 | 17.08 | 112.22 | 1158.4 | 6.38 | 1.19 |
| Sn | Br | P | 7.92 | 8.83 | 17.15 | 112.60 | 1107.1 | 4.82 | 1.21 |
| Ge | Br | P | 7.54 | 8.63 | 16.49 | 112.55 | 991.0 | 4.30 | 1.65 |
| Si | Br | P | 7.26 | 8.53 | 16.59 | 113.48 | 942.4 | 3.43 | 1.35 |

(continued)

| M | X | Q | $a/\text{Å}$ | $b/\text{Å}$ | $c/\text{Å}$ | $\beta/°$ | $V/\text{Å}^3$ | $\rho/\text{gcm}^{-3}$ | $\Delta Eg/eV$ |
|---|---|---|---|---|---|---|---|---|---|
| Pb | Cl | P | 8.29 | 8.51 | 16.58 | 114.77 | 1061.8 | 5.99 | 1.12 |
| Sn | Cl | P | 8.02 | 8.31 | 16.70 | 115.23 | 1006.2 | 4.28 | 1.15 |
| Ge | Cl | P | 7.62 | 8.13 | 15.97 | 113.95 | 904.1 | 3.58 | 1.51 |
| Si | Cl | P | 7.34 | 7.92 | 15.93 | 111.63 | 861.5 | 2.55 | 1.09 |
| Pb | F | P | 8.72 | 7.91 | 14.41 | 121.23 | 849.9 | 7.03 | 1.45 |
| Sn | F | P | 8.40 | 7.31 | 14.70 | 122.76 | 758.6 | 5.17 | 0.01 |
| Ge | F | P | 7.82 | 7.41 | 14.64 | 118.01 | 749.4 | 3.80 | 1.32 |
| Si | F | P | 7.61 | 7.25 | 14.57 | 118.63 | 705.7 | 2.57 | 0.25 |

Table 3: Predicted lattice parameters from DFT-LDA calculations for completely substituted compounds *MXQ* for *M* = Pb, Sn, Ge, Si, *X* = F, Cl, Br, I, *Q* = P. An error of +/- 5 % for each value must be taken into account.

| | distances helix Q [Å] | | | | distances helix *MX* [Å] | | | | | | |
|---|---|---|---|---|---|---|---|---|---|---|---|
| | *Q3-Q3* | *Q2-Q3* | *Q1-Q2* | *Q4-Q1* | *X3-M2* | *M3-X3* | *M3-X2* | *M4-X2* | *M2-X1* | *M1-X1* | *M1-X4* |
| PbIP | 2.16 | 2.18 | 2.18 | 2.20 | 3.21 | 3.15 | 3.21 | 3.11 | 3.20 | 3.22 | 3.21 |
| SnIP | 2.20 | 2.19 | 2.20 | 2.21 | 3.29 | 3.06 | 3.21 | 3.06 | 3.12 | 3.18 | 3.17 |
| GeIP | 2.18 | 2.20 | 2.20 | 2.21 | 3.06 | 2.89 | 3.03 | 2.89 | 2.95 | 2.99 | 3.01 |
| SiIP | 2.19 | 2.21 | 2.21 | 2.21 | 3.07 | 2.78 | 3.00 | 2.82 | 2.82 | 2.97 | 2.91 |
| PbBrP | 2.16 | 2.17 | 2.18 | 2.19 | 3.09 | 2.98 | 3.03 | 2.96 | 3.01 | 3.04 | 3.03 |
| SnBrP | 2.17 | 2.18 | 2.19 | 2.19 | 2.98 | 2.88 | 2.97 | 2.89 | 2.93 | 2.94 | 2.98 |
| GeBrP | 2.18 | 2.18 | 2.19 | 2.19 | 2.92 | 2.69 | 2.89 | 2.73 | 2.74 | 2.85 | 2.82 |
| SiBrP | 2.20 | 2.20 | 2.20 | 2.20 | 3.18 | 2.49 | 2.94 | 2.65 | 2.47 | 3.04 | 2.61 |
| PbClP | 2.17 | 2.17 | 2.17 | 2.18 | 2.99 | 2.85 | 2.92 | 2.86 | 2.87 | 2.95 | 2.90 |
| SnClP | 2.17 | 2.17 | 2.18 | 2.18 | 2.88 | 2.75 | 2.85 | 2.79 | 2.79 | 2.83 | 2.86 |
| GeClP | 2.17 | 2.17 | 2.19 | 2.19 | 2.54 | 2.66 | 2.70 | 2.64 | 2.95 | 2.49 | 2.95 |
| SiClP | 2.16 | 2.18 | 2.20 | 2.21 | 2.27 | 2.75 | 2.44 | 2.58 | 3.35 | 2.24 | 3.03 |
| PbFP | 2.18 | 2.18 | 2.17 | 2.15 | 2.92 | 2.55 | 2.87 | 2.38 | 2.29 | 3.50 | 2.35 |
| SnFP | 2.19 | 2.18 | 2.17 | 2.16 | 2.51 | 2.49 | 2.90 | 2.39 | 2.15 | 3.24 | 2.39 |
| GeFP | 2.19 | 2.16 | 2.17 | 2.18 | 1.88 | 3.40 | 2.01 | 2.33 | 3.55 | 1.86 | 3.06 |
| SiFP | 2.18 | 2.17 | 2.18 | 2.18 | 1.67 | 3.47 | 1.82 | 2.28 | 3.62 | 1.66 | 3.23 |

Description of Figures

Figure 1 shows the crystal structure of SnIP with a view along the a axis (Fig. 1a) and *b* axis (Fig. 1b).

Figure 2 shows an SEM picture of (bulk) SnIP.

Figure 3 shows a comparison of a measured X-ray powder diffractogram of SnIP and a X-ray powder diffractogram calculated from single crystal structure data. Measurement was performed at room temperature.

Figure 4 show the results of Raman spectroscopy of SnIP at room temperature.

Figure 5 shows Mössbauer spectra of SnIP at 298 (top) and 77 K (bottom).

Figure 6 shows the susceptibility of SnIP.

Figure 7 shows the $^{31}P$ solid state NMR spectrum of SnIP.

Figure 8 shows high resolution SEM pictures of exfoliated SnIP crystals. 8a: Mechanically (tape method) delaminated crystals of 30 nm diameter of SnIP. 8b: Chemically delaminated SnIP crystal of the same size prepared on a copper grid. 8c: TEM measurement of a SnIP nano tube with around 10 nm..

Figure 9 shows the structure and bond lengths in *MQX* compounds, as predicted by DFT calculations for *M* = Pb, Sn, Ge, Si, *X* = F, Cl, Br, I, Q = P (see Table 2, Table 3, and Text).

Figure 10 shows microphotographs of GeIP.

Figure 11 shows microphotographs of GeIAs.

Figure 12 shows microphotographs of PbIP.

Figure 13 shows microphotographs of PbBrP.

Figure 14 shows microphotographs of $Sn_{0.5}Pb_{0.5}IP$

Figure 15 shows the results from diffuse reflectance measurements of SnIP, drawn according the Kubelka-Munk theory. The direct band gap was calculated to ~1.86 eV.

Figure 16 shows the room temperature photoluminescence of SnIP with a luminescence maximum at 1.86 eV.

**Claims**

1. A compound of formula (Ia):

$$M^A_{1-x}M^B_xX^A_{1-y}X^B_yQ^A_{1-z}Q^B_z \qquad (Ia),$$

wherein:

$M^A$ is an element selected from Si, Ge, Sn, and Pb,
$M^B$ is an element selected from Si, Ge, Sn, and Pb and from combinations thereof such that $M^B$ is not the same as $M^A$ and does not contain $M^A$, and
x is 0 to 0.50;
$X^A$ is an element selected from F, Cl, Br and I,
$X^B$ is an element selected from F, Cl, Br and I and from combinations thereof such that $X^B$ is not the same as $X^A$ and does not contain $X^A$, and
y is 0 to 0.50;

$Q^A$ is an element selected from P, As, Sb and Bi,
$Q^B$ is an element selected from P, As, Sb and Bi and from combinations thereof such that $Q^B$ is not the same as $Q^A$ and does not contain $Q^A$,
z is 0 to 0.50;

or a compound which is a doped variant of the compound of formula (Ia), and which further contains:

an element $M^D$, selected from Al, Ga, In and from combinations thereof, in a maximum amount of 10 mol% based on the total molar amount of $M^A$ and $M^B$, which element $M^D$ may partially replace $M^A$ and/or $M^B$ in formula (Ia); and/or
an element $Q^D$, selected from S, Se, Te and from combinations thereof, in a maximum amount of 10 mol% based on the total molar amount of $X^A$, $X^B$, $Q^A$ and $Q^B$, which element $Q^D$ may partially replace $X^A$, $X^B$, $Q^A$ and/or $Q^B$ in formula (Ia).

2. The compound in accordance with claim 1, which is a compound of formula (II):

$$(M^A_{1-x}M^B_x)_{1-3m}M^D_{2m}X^A_{1-y}X^B_y(Q^A_{1-z}Q^B_z)_{1-2n}Q^D_n \qquad \text{(II)},$$

wherein $M^A$, $M^B$, $X^A$, $X^B$, $Q^A$, $Q^B$, x, y and z are defined as in claim 1, and wherein

$M^D$ is an element selected from Al, Ga and In and from combinations thereof,
$Q^D$ is an element selected from S, Se and Te and from combinations thereof,
m is 0 to 0.03; and
n is 0 to 0.10.

3. The compound in accordance with claim 2, which is a compound of formula (IIIa), (IIIb), (IIIc) or (IIId):

$$M^A_{1-3m}M^D_{2m}X^A(Q^A_{1-z}Q^B_z)_{1-2n}Q^D_n \qquad \text{(IIIa)},$$

$$M^A_{1-3m}M^D_{2m}X^A_{1-y}X^B_yQ^A_{1-2n}Q^D_n \qquad \text{(IIIb)},$$

$$(M^A_{1-x}M^B_x)_{1-3m}M^D_{2m}X^AQ^A_{1-2n}Q^D_n \qquad \text{(IIIc)},$$

$$M^A_{1-3m}M^D_{2m}X^AQ^A_{1-2n}Q^Dn \qquad \text{(IIId)},$$

wherein $M^A$, $M^B$, $X^A$, $X^B$, $Q^A$, $Q^B$, $M^D$, $Q^D$, x, y, z, m and n are defined as in claim 2.

4. The compound in accordance with claim1, which is a compound of formula (IVa), (IVb), (IVc) or (IVd)

$$M^AX^AQ^A_{1-z}Q^B_z \qquad \text{(IVa)},$$

$$M^AX^A_{1-y}X^B_yQ^A \qquad \text{(IVb)},$$

$$M^A_{1-x}M^B_xX^AQ^A \qquad \text{(IVc)},$$

$$M^AX^AQ^A \qquad \text{(IVd)},$$

wherein $M^A$, $M^B$, $X^A$, $X^B$, $Q^A$, $Q^B$, x, y and z, are defined as in claim 1.

5. The compound in accordance with any of claims 2 or 3, wherein m is 0 to 0.01 and n is 0 to 0.01.

6. The compound in accordance with any of claims 1 to 5, wherein x is 0 to 0.15, y is 0 to 0.15 and z is 0 to 0.15.

7. The compound in accordance with any of claims 1 to 6, wherein $M^A$ is Sn.

8. The compound in accordance with any of claims 1 to 7, wherein $X^A$ is I.

9. The compound in accordance with any of claims 1 to 8, wherein $Q^A$ is P.

**10.** The compound in accordance with claim 1, which is selected from GeIP, GeBrP, GeClP, GeFP, GeIAs, GeClAs, GeFAs, SnIP, SnBrP, SnClP, SnFP, SnIAs, SnBrAs, SnClAs, SnFAs, SnISb, SnBrSb, SnClSb, SnFSb, PbIP, PbBrP, PbClP, PbFP, PbIAs, PbBrAs, PbClAs, PbFAs, PbIBi, PbBrBi, PbClBi, and PbFBi.

**11.** The compound in accordance with any of claims 1 to 10 which is in the form of a nanowire.

**12.** A process for the production of the compound in accordance with claim 11, comprising the steps of:

a) mixing starting materials selected from (i) elements contained in the compound, (ii) precursor compounds formed from elements contained in the compound, and (iii) combinations of (i) and (ii) in the desired stoichiometric amounts;
b) reacting the starting materials under heat in an inert atmosphere;
c) exfoliating the obtained material to prepare the compound in the form of a nanowire.

**13.** A solar cell, a thermoelectric device or a sensor comprising the compound in accordance with any of claims 1 to 11.

**14.** Use of a compound in accordance with any of claims 1 to 11 as a semiconductor in an electrical, electronic, optical, or optoelectronic device.

**15.** Use of a compound in accordance with any of claims 1 to 11 as a photocatalyst.

**Patentansprüche**

**1.** Eine Verbindung der Formel (Ia):

$$M^A_{1-x}M^B_xX^A_{1-y}X^B_yQ^A_{1-z}Q^B_z \qquad \text{(Ia)},$$

wobei:

$M^A$ ein Element ist, das aus Si, Ge, Sn und Pb ausgewählt ist,
$M^B$ ein Element ist, das aus Si, Ge, Sn und Pb und aus Kombinationen davon ausgewählt ist, sodass $M^B$ nicht gleich $M^A$ ist und $M^A$ nicht enthält, und
$x$ 0 bis 0,50 ist;
$X^A$ ein Element ist, das aus F, Cl, Br und I ausgewählt ist,
$X^B$ ein Element ist, das aus F, Cl, Br und I und aus einer Kombination davon ausgewählt ist, sodass $X^B$ nicht gleich $X^A$ ist und $X^A$ nicht enthält, und
$y$ 0 bis 0,50 ist;
$Q^A$ ein Element ist, das aus P, As, Sb und Bi ausgewählt ist,
$Q^B$ ein Element ist, das aus P, As, Sb und Bi und aus Kombinationen davon ausgewählt ist, sodass $Q^B$ nicht gleich $Q^A$ ist und $Q^A$ nicht enthält,
$z$ 0 bis 0,50 ist;

oder eine Verbindung, die eine dotierte Variante der Verbindung von Formel (Ia) ist und die ferner enthält:

ein Element $M^D$, ausgewählt aus Al, Ga, In und aus Kombinationen davon, in einer maximalen Menge von 10 Mol-%, bezogen auf die gesamte Molmenge von $M^A$ und $M^B$, wobei Element $M^D$ $M^A$ und/oder $M^B$ in Formel (Ia) teilweise ersetzen kann; und/oder
ein Element $Q^D$, ausgewählt aus S, Se, Te und aus Kombinationen davon, in einer maximalen Menge von 10 Mol-%, bezogen auf die gesamte Molmenge von $X^A$, $X^B$, $Q^A$ und $Q^B$, wobei Element $Q^D$ $X^A$, $X^B$, $Q^A$ und/oder $Q^B$ in Formel (Ia) teilweise ersetzen kann.

**2.** Die Verbindung gemäß Anspruch 1, die eine Verbindung der Formel (II) ist:

$$(M^A_{1-x}M^B_x)_{1-3m}M^D_{2m}X^A_{1-y}X^B_y(Q^A_{1-z}Q^B_z)_{1-2n}Q^D_n \qquad \text{(II)},$$

wobei $M^A$, $M^B$, $X^A$, $X^B$, $Q^A$, $Q^B$, $x$, $y$ und $z$ wie in Anspruch 1 definiert sind und wobei

$M^D$ ein Element ist, das aus Al, Ga und In und aus Kombinationen davon ausgewählt ist,
$Q^D$ ein Element ist, das aus S, Se und Te und aus Kombinationen davon ausgewählt ist,
m 0 bis 0,03 ist; und
n 0 bis 0,10 ist.

3. Die Verbindung gemäß Anspruch 2, die eine Verbindung der Formel (IIIa), (IIIb), (IIIc) oder (IIId) ist:

$$M^A_{1-3m}M^D_{2m}X^A(Q^A_{1-z}Q^B_z)_{1-2n}Q^D_n \qquad \text{(IIIa)},$$

$$M^A_{1-3m}M^D_{2m}X^A_{1-y}X^B_yQ^A_{1-2n}Q^D_n \qquad \text{(IIIb)},$$

$$(M^A_{1-x}M^B_x)_{1-3m}M^D_{2m}X^AQ^A_{1-2n}Q^D_n \qquad \text{(IIIc)},$$

$$M^A_{1-3m}M^D_{2m}X^AQ^A_{1-2n}Q^D_n \qquad \text{(IIId)},$$

wobei $M^A$, $M^B$, $X^A$, $X^B$, $Q^A$, $Q^B$, $M^D$, $Q^D$, x, y, z, m und n wie in Anspruch 2 definiert sind.

4. Die Verbindung gemäß Anspruch 1, die eine Verbindung der Formel (IVa), (IVb), (IVc) oder (IVd) ist:

$$M^AX^AQ^A_{1-z}Q^B_z \qquad \text{(IVa)},$$

$$M^AX^A_{1-y}X^B_yQ^A \qquad \text{(IVb)},$$

$$M^A_{1-x}M^B_xX^AQ^A \qquad \text{(IVc)},$$

$$M^AX^AQ^A \qquad \text{(IVd)},$$

wobei $M^A$, $M^B$, $X^A$, $X^B$, $Q^A$, $Q^B$, x, y, und z wie in Anspruch 1 definiert sind.

5. Die Verbindung gemäß einem der Ansprüche 2 oder 3, wobei m 0 bis 0,01 und n 0 bis 0,01 ist.

6. Die Verbindung gemäß einem der Ansprüche 1 bis 5, wobei x 0 bis 0,15, y 0 bis 0,15 und z 0 bis 0,15 ist.

7. Die Verbindung gemäß einem der Ansprüche 1 bis 6, wobei $M^A$ Sn ist.

8. Die Verbindung gemäß einem der Ansprüche 1 bis 7, wobei $X^A$ I ist.

9. Die Verbindung gemäß einem der Ansprüche 1 bis 8, wobei $Q^A$ P ist.

10. Die Verbindung gemäß Anspruch 1, die aus GeIP, GeBrP, GeClP, GeFP, GeIAs, GeBrAs, GeClAs, GeFAs, SnIP, SnBrP, SnClP, SnFP, SnIAs, SnBrAs, SnClAs, SnFAs, SnISb, SnBrSb, SnClSb, SnFSb, PbIP, PbBrP, PbClP, PbFP, PbIAs, PbBrAs, PbClAs, PbFAs, PbIBi, PbBrBi, PbClBi und PbFBi ausgewählt ist.

11. Die Verbindung gemäß einem der Ansprüche 1 bis 10, die in der Form eines Nanodrahtes vorliegt.

12. Ein Verfahren zur Herstellung der Verbindung gemäß Anspruch 11, umfassend die Schritte des:

a) Mischens der Ausgangsmaterialien, ausgewählt aus (i) Elementen, die in der Verbindung enthalten sind, (ii) Vorläuferverbindungen, die aus in der Verbindung enthaltenen Elementen geformt sind, und (iii) Kombinationen von (i) und (ii) in den gewünschten stöchiometrischen Mengen;
b) Umsetzens der Ausgangsmaterialien unter Wärme in einer inerten Atmosphäre;
c) Ablösens des erhaltenen Materials, um die Verbindung in der Form eines Nanodrahtes herzustellen.<

13. Eine Solarzelle, eine thermoelektrische Vorrichtung oder ein Sensor, umfassend die Verbindung gemäß einem der Ansprüche 1 bis 11.

14. Verwendung einer Verbindung gemäß einem der Ansprüche 1 bis 11 als Halbleiter in einer elektrischen, elektronischen, optischen oder optoelektronischen Vorrichtung.

**15.** Verwendung einer Verbindung gemäß einem der Ansprüche 1 bis 11 als Photokatalysator.

**Revendications**

**1.** Composé de formule (Ia) :

$$M^A_{1-x}M^B_xX^A_{1-y}X^B_yQ^A_{1-z}Q^B_z \qquad (Ia),$$

dans laquelle :

$M^A$ est un élément choisi parmi Si, Ge, Sn et Pb,
$M^B$ est un élément choisi parmi Si, Ge, Sn et Pb et parmi leurs combinaisons de sorte que $M^B$ ne soit pas identique à $M^A$ et ne contienne pas $M^A$, et
$x$ vaut de 0 à 0,50 ;
$X^A$ est un élément choisi parmi F, Cl, Br et I,
$X^{13}$ est un élément choisi parmi F, Cl, Br et I et parmi leurs combinaisons de sorte que $X^{13}$ ne soit pas identique à $X^A$ et ne contienne pas $X^A$, et
$y$ vaut de 0 à 0,50 ;
$Q^A$ est un élément choisi parmi P, As, Sb et Bi,
$Q^{13}$ est un élément choisi parmi P, As, Sb et Bi et parmi leurs combinaisons de sorte que $Q^{13}$ ne soit pas identique à $Q^A$ et ne contienne pas $Q^A$,
$z$ vaut de 0 à 0,50 ;

ou un composé qui est une variante dopée du composé de formule (Ia), et qui contient en outre :

un élément $M^D$, choisi parmi Al, Ga, In et parmi leurs combinaisons, en une quantité maximale de 10 % en moles par rapport à la quantité molaire totale de $M^A$ et $M^B$, lequel élément $M^D$ peut partiellement remplacer $M^A$ et/ou $M^B$ dans la formule (Ia) ; et/ou
un élément $Q^D$, choisi parmi S, Se, Te et parmi leurs combinaisons, en une quantité maximale de 10 % en moles par rapport à la quantité molaire totale de $X^A$, $X^B$, $Q^A$ et $Q^B$, lequel élément $Q^D$ peut partiellement remplacer $X^A$, $X^B$, $Q^A$ et/ou $Q^B$ dans la formule (Ia).

**2.** Composé selon la revendication 1, qui est un composé de formule (II) :

$$(M^A_{1-x}M^B_x)_{1-3m}M^D_{2m}X^A_{1-y}X^B_y(Q^A_{1-z}Q^B_z)_{1-2n}Q^D_n \qquad (II),$$

dans laquelle $M^A$, $M^B$, $X^A$, $X^B$, $Q^A$, $Q^B$, x, y et z sont tels que définis dans la revendication 1, et dans laquelle

$M^D$ est un élément choisi parmi Al, Ga et In et parmi leurs combinaisons,
$Q^D$ est un élément choisi parmi S, Se et Te et parmi leurs combinaisons,
$m$ vaut de 0 à 0,03 ; et
$n$ vaut de 0 à 0,10.

**3.** Composé selon la revendication 2, qui est un composé de formule (IIIa), (IIIb), (IIIc) ou (IIId) :

$$M^A_{1-3m}M^D_{2m}X^A(Q^A_{1-z}Q^B_z)_{1-2n}Q^D_n \qquad (IIIa),$$

$$M^A_{1-3m}M^D_{2m}X^A_{1-y}X^B_yQ^A_{1-2n}Q^D_n \qquad (IIIb).$$

$$(M^A_{1-x}M^B_x)_{1-3m}M^D_{2m}X^AQ^A_{1-2n}Q^D_n \qquad (IIIc),$$

$$M^A_{1-3m}M^D_{2m}X^AQ^A_{1-2n}Q^D_n \qquad (IIId),$$

formules dans lesquelles $M^A$, $M^B$, $X^A$, $X^B$, $Q^A$, $Q^B$, $M^D$, $Q^D$, x, y, z, m et n sont tels que définis dans la revendication 2.

**4.** Composé selon la revendication 1, qui est un composé de formule (IVa), (IVb), (IVc) ou (IVd) :

$$M^A X^A Q^A_{1-z} Q^B_z \qquad \text{(IVa)},$$

$$M^A X^A_{1-y} X^B_y Q^A \qquad \text{(IVb)},$$

$$M^A_{1-x} M^B_x X^A Q^A \qquad \text{(IVc)},$$

$$M^A X^A Q^A \qquad \text{(IVd)},$$

formules dans lesquelles $M^A$, $M^B$, $X^A$, $X^B$, $Q^A$, $Q^B$, x, y et z sont tels que définis dans la revendication 1.

5. Composé selon l'une quelconque des revendications 2 ou 3, dans lequel m vaut de 0 à 0,01 et n vaut de 0 à 0,01.

6. Composé selon l'une quelconque des revendications 1 à 5, dans lequel x vaut de 0 à 0,15, y vaut de 0 à 0,15 et z vaut de 0 à 0,15.

7. Composé selon l'une quelconque des revendications 1 à 6, dans lequel $M^A$ est Sn.

8. Composé selon l'une quelconque des revendications 1 à 7, dans lequel $X^A$ est I.

9. Composé selon l'une quelconque des revendications 1 à 8, dans lequel $Q^A$ est P.

10. Composé selon la revendication 1, qui est choisi parmi GeIP, GeBrP, GeClP, GeFP, GeIAs, GeBrAs, GeClAs, GeFAs, SnIP, SnBrP, SnClP, SnFP, SnIAs, SnBrAs, SnClAs, SnFAs, SnISb, SnBrSb, SnClSb, SnFSb, PbIP, PbBrP, PbClP, PbFP, PbIAs, PbBrAs, PbClAs, PbFAs, PbIBi, PbBrBi, PbClBi, et PbFBi.

11. Composé selon l'une quelconque des revendications 1 à 10, qui est sous la forme d'un nanofil.

12. Procédé pour la production du composé selon la revendication 11, comprenant les étapes de :

    a) mélange de matériaux de départ choisis parmi (i) des éléments contenus dans le composé, (ii) des composés précurseurs formés d'éléments contenus dans le composé, et (iii) des combinaisons de (i) et (ii) en les quantités stœchiométriques souhaitées ;
    b) réaction des matériaux de départ sous chaleur dans une atmosphère inerte ;
    c) exfoliation du matériau obtenu pour que le composé soit préparé sous la forme d'un nanofil.

13. Cellule solaire, dispositif thermoélectrique ou capteur comprenant le composé selon l'une quelconque des revendications 1 à 11.

14. Utilisation d'un composé selon l'une quelconque des revendications 1 à 11 en tant que semi-conducteur dans un dispositif électrique, électronique, optique ou optoélectronique.

15. Utilisation d'un composé selon l'une quelconque des revendications 1 à 11 en tant que photocatalyseur.

Sn
I
P

Fig 1a

Fig. 1b

Fig. 2

Fig. 3

Fig. 4.

Fig. 5.

Fig. 6

Fig. 7

Fig.8a

Fig. 8b

Fig. 8c

Fig. 9

Fig. 10

Fig.11

Fig. 12

Fig. 13

Fig. 14

Fig. 15

Fig. 16

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **ZHAO, M. Q. et al.** *Nanoscale,* 2014, vol. 6, 9339
- **LIJIMA, S. et al.** *Nature,* 1993, vol. 363, 603
- **SOGHOMONIAN et al.** *Science,* 1993, vol. 259, 1596
- **IVANOV, A. S. et al.** *Angew. Chem. Int. Ed.,* 2012, vol. 51, 8330
- **LIU, L. et al.** *Nanoscale,* 2014, vol. 6, 9355
- **SONE, E.D. et al.** *Small,* 2005, vol. 1, 694
- **GOLDBERGER, J. et al.** *Nature,* 2003, vol. 422, 599
- **WANG, Y.** *JACS,* 2011, vol. 133, 20060
- **MORITO, H.** *Angew. Chem. Int. Ed.,* 2010, vol. 49, 3628
- **SUN, W. et al.** *Science,* 2014, vol. 346, 6210
- **GRAETZEL, M. et al.** *Nature,* 2012, vol. 488, 304
- **BOUKAI, A. I. et al.** *Nature,* 2008, vol. 451, 168
- **CHUNG, I. et al.** *Nature,* 2012, vol. 485, 486
- **BISWAS, K. et al.** *Nature,* 2012, vol. 489, 414
- **VON SCHNERING, H.G. et al.** *Angew. Chem.,* 1972, vol. 84, 30
- **VON SCHNERING, H.G.** *Z. Anorg. Chem.,* 1973, vol. 395, 223
- **SHATRUK M. M. et al.** *Inorg. Chem.,* 1999, vol. 38, 3455
- **X. WANG ; K. L. PEY ; C. H. YIP ; E. A. FITZGERALD ; D. A. ANTONIADIS.** *J. Appl. Phys.,* 2010, vol. 108, 124303
- **D. T. MOORE ; B. GASKEY ; A. ROBBINS ; T. HANRATH.** *J. Appl. Phys.,* 2014, vol. 115, 054313
- **G. KONSTANTATOS ; E. H. SARGENT.** Colloidal Quantum Dot Optoelectronics and Photovoltaics. Cambridge press
- **B. SOTHMANN ; R. SÁNCHEZ ; A. N. JORDAN.** *Nanotechnology,* 2015, vol. 26 (032001), 23
- **K. BISWAS et al.** *Nature,* 2012, vol. 489, 414-418
- **J. GOLDBERGER ; R. FAN ; P. YANG.** *Acc. Chem. Res.,* 2006, vol. 39, 239
- **S. SU ; W. WU ; J. GAO ; J. LU ; C. FAN.** *J Mater. Chem.,* 2012, vol. 22, 18101
- **Z. TANG ; N. A. KOTOV ; M. GIERSING.** *Science,* 2002, vol. 297, 237-240
- **G. KUMAR ; H. X. TANG ; J. SCHROERS.** *Nature,* 2009, vol. 457, 868-872
- **PETRICEK, V. et al.** *Z. Kristallogr.,* 2014, vol. 229, 345
- **KRESSE G. ; FURTHMÜLLER J.** *Phys. Rev. B,* 1996, vol. 54, 11169
- **KRESSE G. ; HAFNER J.** *J. Phys.: Condens. Matter,* 1994, vol. 6, 8245
- **DOVESI et al.** CRYSTAL14 User's Manual. University of Torino, 2014
- **DOVESI, R. et al.** *Int. J. Quantum Chem.,* 2014, vol. 114, 1287
- **J. P. PERDEW ; Y. WANG.** Accurate and simple analytic representation of the electron-gas correlation energy. *Phys. Rev. B.,* 1992, vol. 45, 13244-13249
- **V. KRUKAU ; O. A. VYDROV ; A. F. IZMAYLOV ; G. E. SCUSERIA.** Influence of the exchange screening parameter on the performance of screened hybrid functionals. *J. Chem. Phys.,* 2006, vol. 125, 224106